Europäisches Patentamt

(19) European Patent Office

Office européen des brevets

(11) Publication number: **0 063 421**
**B1**

## EUROPEAN PATENT SPECIFICATION

(45) Date of publication of patent specification: **06.05.87**

(51) Int. Cl.⁴: **H 01 L 31/08**

(21) Application number: **82301603.5**

(22) Date of filing: **26.03.82**

(54) High speed photoconductive detector.

(30) Priority: **20.04.81 US 255595**

(43) Date of publication of application:
**27.10.82 Bulletin 82/43**

(45) Publication of the grant of the patent:
**06.05.87 Bulletin 87/19**

(84) Designated Contracting States:
**DE FR GB NL SE**

(56) References cited:
**EP-A-0 063 422**
**NL-A-7 412 624**
**US-E- 28 610**

**APPLIED PHYSICS LETTERS, vol. 37, no. 11, December 1980, pages 1014-1016, New York, USA; C.W. CHEN et al.: "A high-speed Si lateral photodetector fabricated over an etched interdigital mesa"**

**IEEE TRANSACTIONS ON ELECTRON DEVICES, vol. ED-26, no. 11, November 1979, pages 1855-1866, New York, USA; T. SUGETA et al.: "High-gain metal-semiconductor-metal photodetectors for high-speed optoelectronic circuits"**

(73) Proprietor: **Hughes Aircraft Company**
**7200 Hughes Terrace P.O. Box 45066**
**Los Angeles California 90045-0066 (US)**

(72) Inventor: **Slayman, Charles W.**
**3359 Holloway Street**
**Newbury Park California 91320 (US)**
Inventor: **Figueroa, Luis**
**22240 Victory, E-311**
**Woodland Hills California 91367 (US)**

(74) Representative: **Colgan, Stephen James et al**
**CARPMAELS & RANSFORD 43 Bloomsbury Square**
**London WC1A 2RA. (GB)**

Courier Press, Leamington Spa, England.

# Description

## Background of the invention

### 1. Field of the invention

This invention relates to high speed photodetectors, and, more particularly, to high speed photodetectors incorporating an interdigital metal electrode pattern forming non-blocking contacts integrated with a transmission line.

### 2. Description of the prior art

Conventional photoconductive detectors rely on the difference in the transit time of one carrier type versus the recombination time of the other carrier type to achieve gain. This is at the cost of device speed. The use of a photosensitive two-terminal devices for high speed photodetection has been proposed by Sugeta et al, Vol. ED-26, IEEE Transactions on Electron Devices, pp. 1855—1856 (1979) and Gammel et al, IEDM Technical Digest, pp. 634—637 (1979). However, both types of devices rely on blocking contacts and are recombination-time limited.

The aforementioned article of Sugeta et al describes a high speed photodetector consisting of a GaAs substrate, a pair of interdigitated metal electrodes with a spacing of 5 μm forming a Schottky contact with said substrate and output electrodes.

## Summary of the invention

In accordance with the invention, a high speed photoconductive detector responsive to incident optical radiation comprises:

(a) a region of semiconductor material capable of withstanding a high enough electric field to permit generation of holes and electrons at their saturation velocity and having a bandgap less than the energy of the incident optical radiation;

(b) a pair of interdigitated metal electrodes formed on the region, the metal electrodes forming non-blocking contacts with the region, with each digit less than about 5 μm apart; and

(c) means for connecting each metal electrode to a transmission line.

In this device, current will be induced under optical illumination due to photo-carrier generation. The interdigital geometry allows for large device cross-section and small carrier transit distance. The use of non-blocking contacts permits high speed operation of the device (less than about 50 ps), while the small carrier transit distance implies low transit time and thus high efficiency. Integration with a transmission line eliminates the need for bonding wires.

## Brief description of the drawing

Fig. 1 is a plan view showing a pattern of interdigitated metal electrodes on a semiconductor surface; and

Fig. 2 is a cross-section view through 2—2 of Fig. 1, depicting a preferred embodiment of the invention.

## Detailed description of the invention

In order to obtain high speed photodetection, carrier transit time and device circuit parasitics must be taken into account. A two-terminal photoconductor for high speed and high sensitivity photodetection is provided herein. The device comprises two metal electrodes separated by a photosensitive barrier or semiconductor material. The geometry of the device is such that (1) there is a relatively large active area, (2) the electrodes are placed in close proximity so that photo-carriers generated by incident optical radiation are rapidly swept out of the semiconductor, and (3) the effect of parasitic circuit elements is minimized. The electrodes and semiconductor material are selected such that (1) high bias fields can be used to achieve maximum photocarrier velocities, (2) bulk surface and metal/semiconductor interface trapping effects are eliminated in order to prevent anomalous low frequency response, and (3) photo-carrier transit times are less than recombination times to allow for high internal collection efficiencies.

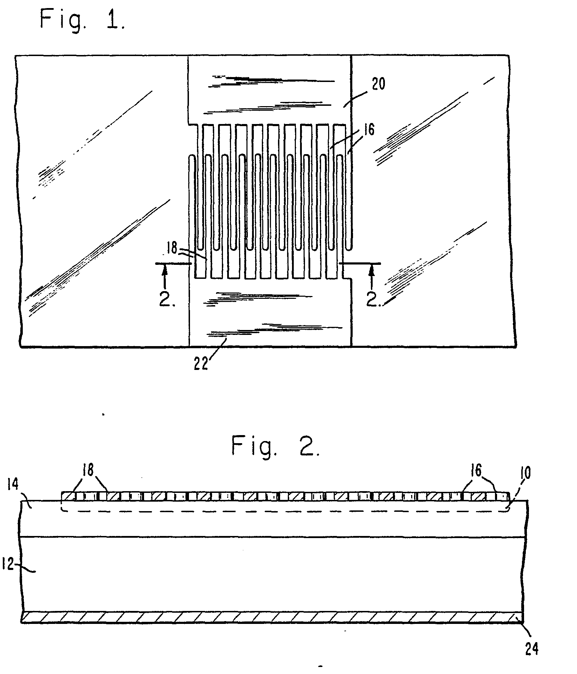

Referring to Figs. 1 and 2, and noting that the horizontal scale of Fig. 2 has been expanded for clarity, the device of the invention comprises first a region 10 of semiconductor material, called the active region, capable of withstanding an electric field to permit generation of holes and electrons at their saturation velocity and having a bandgap less than the energy of the incident optical radiation. For example, a device employing silicon, which has a bandgap of 1.1 eV, will be responsive to optical radiation having a wavelength less than 1.1 μm, while a device employing GaAs, which has a bandgap of 1.4 eV, will be responsive to optical radiation having a wavelength less than 0.88 μm. The semiconductor material may comprise a substrate 12, in which, under application of a bias, is formed the active region 10. Alternatively, and preferably, as depicted in Fig. 2, the active region is formed in a portion of an epitaxial layer 14 grown on a major surface of the substrate to a thickness sufficient (a) to isolate the substrate during operation and (b) to absorb incident light. Again, the active region 10 is created by application of a bias. An epitaxial layer is desirably employed if the bulk substrate material displays trapping effects. Trapping of carriers reduces operating speed of the device and thus is to be avoided.

The substrate 12 of the photoconductive detector preferably comprises a semi-insulating substrate of silicon or germanium or a III—V compound such as GaAs or InP or a II—VI compound such as PbTe. Such a semi-insulating substrate provides a lateral flow of carriers, as contrasted to a conventional PIN detector on a conducting substrate in which a vertical flow of carriers is obtained. A lateral flow of carriers is obtained only with high fields across electrodes on the same surface.

Epitaxial layer 14, if employed, preferably comprises an undoped (or unintentionally doped) semiconductor material of the classes listed above. For example undoped GaAs, which has a carrier concentration of about $10^{15}/cm^3$, is advantageously employed. A semi-insulating substrate, of the material described above, is desirably employed in conjunction with the epitaxial layer. For example, a semi-insulating substrate of GaAs (e.g., Cr-doped) may be used to support an epitaxial layer of unintentionally doped n-type GaAs. Or, a semi-insulating substrate of InP may be used to support an epitaxial layer of unintentionally doped n-type (Ga, In) As.

The thickness of the substrate, whether used alone or in conjunction with an epitaxial layer, should be such as to provide adequate mechanical support. Further constraints on substrate thickness are described below.

The thickness of the epitaxial layer should be sufficient to avoid photogeneration in the bulk material. Accordingly, a thickness of at least about 1 µm is required. Preferably, the thickness ranges from about 3 to 5 µm. Thicker layers may be employed, providing the epitaxial layer is of sufficiently high resistance to maintain device performance, preferably greater than about $10,000 \cdot \Omega$-cm.

To achieve maximum speed, the device must be operated at saturation velocity. In III—V materials, electron velocity saturates rapidly with an electric field, while hole velocity saturates comparatively slowly. Therefore, the device must be operated at a high enough field to saturate the hole velocity. For GaAs, this requires fields on the order of 30 to 100 kV/cm. Thus, the material in which the active region 10 is formed must be one which can withstand high electric fields without breaking down in order to realize the high speed properties of the device. Also, the material in which the active region is formed should have a band gap less than the energy of the incident optical radiation in order to absorb substantially all incident optical radiation. High quality material is ensured by employing material in which the room temperature mobility of electrons is greater than about 3,000 cm²/V-s (for III—V compounds).

The device further comprises a pair of interdigitated metal electrodes 16, 18 formed on the region of semiconductor material. Only metal electrodes which form non-blocking contacts with the active region are employed in order to provide transit time-limited performance. Examples of metal electrodes advantageously employed in the device of the invention include aluminum and gold.

The spacing between the interdigitated fingers (distance between neighboring digits) should be no more than about 5 µm; this provides a device rise time (transit time) of about 50 ps and an analog response of about 6 to 8 GHz. Shorter spacings, to the extent they may be economically fabricated, provide correspondingly shorter rise times and higher analog frequency response.

In order to obtain a high collection efficiency, the optical attenuation depth $1/\alpha$, where $\alpha$ is the absorption coefficient of the active region, must be less than the electrode spacing. This provides an additional constraint on the electrode spacing.

The electrodes should be thick enough to minimize series resistance; accordingly, a thickness of about 200 nm (2,000 Å) is sufficient. Conveniently, the well-known photoresist lift-off technique is used to form contacts. Accordingly, the contacts should not be so thick as to provide problems with this technique; a suitable maximum thickness of about 500 nm (5,000 Å).

The area of the interdigital electrodes controls the RC time constant. Therefore, to decrease spacing, the area must also be correspondingly decreased because of capacitive effects between the fingers.

Since the electrodes shadow the active area of the detector, the finger width should be made as narrow as possible for high light collection efficiency.

The electrodes must form non-blocking contacts to the active region in order to prevent trapping of carriers. As a result, high speed operation is achieved. For example, blocking contacts generate a fall time of about 200 ps or so, while non-blocking contacts generate a fall time of about 50 ps or less, where fall time is the time required for a pulse output to drop from 90% to 10% of its peak value.

On semi-insulating substrates, it is immaterial whether the contacts are both ohmic, both Schottky, or one of each, so long as the contacts are non-blocking. On epitaxial semiconductor layers, the contacts may be any combination of ohmic or Schottky, so long as, in the Schottky case, the contacts are in sufficient proximity so that they modify each other's characteristics so as to form non-blocking contacts. This requires a finger spacing, or distance between neighboring digits, of less than 5 µm. Since the distance the Schottky barrier extends into the semiconductor (both vertically and laterally) is an inverse function of carrier concentration, it is preferred that the epitaxial semiconductor layer have a low doping concentration. Most preferably, undoped (or unintentionally doped) semiconductor material, e.g., carrier concentration less than about $10^{15}/cm^3$, is employed.

Internal bias fields are created by using different work function metals for the two electrodes. However, if the same metal is used for both electrodes, the necessity of aligning the two electrodes is eliminated, but the detector must be externally biased. This is accomplished using a conventional microstrip bias Tee to obtain high speed operation.

A microstrip transmission line 20, 22 is connected to each electrode. The microstrip transmission line forms a non-dispersive line, which is preferable because of the non-dispersive property and ease of fabrication. Other connecting lines, such as coplanar transmission lines, may alternatively be used.

Using microstrip lines requires a ground plane 24, to which one of the lines is conventionally grounded (by means not shown). The other line is connected to a coaxial cable (not shown) via a conventional microstrip line launcher. Thus, the need for bonding wires is eliminated.

Although the thickness of the substrate is not critical in fabricating the photodetector of the invention, it must be selected consistent with the design of the transmission line, using well-known techniques.

The microstrip transmission lines are conveniently fabricated simultaneously with the interdigital electrodes, employing procedures well-known in the art, such as sputtering or evaporation. The ground plane is conveniently similarly deposited on the back surface of the substrate or can be formed by securing the photodetector to the surface of a metal carrier.

In order to maintain high sensitivity, a conventional anti-reflection coating (not shown) may be deposited over the photosensitive area (between the interdigital fingers). Further, to ensure photogeneration only in the high field region, an opaque layer (not shown) deposited over the entire structure except the interdigital area may be used. This will prevent slow diffusion currents (generated by unfocused or mis-aligned optical beams) from creating anomalous low frequency response of the detector.

Surface recombination and trapping can be minimized by use of a transparent passivation layer (not shown), formed either over or between the interdigital area that can also serve as an antireflection coating. For example, a thermally-grown $SiO_2$ layer can be used on a photodetector device employing Si. For a GaAs substrate, a thin $Ga_xAl_{1-x}As$ window layer can be grown and oxidized, where $x \geq 0.4$.

In order to make the transit and parasitic RC time constants comparable, the overall interdigital dimensions (i.e., array length by array width) must be properly chosen. The expected response time of the device is easily estimated from the interdigital capacitance C and the carrier transit time $t_{tr}$. For finger width equal to finger spacing w, the static capacitance of a square array is given

$$C = \varepsilon_0 (I + \varepsilon_r) L^2 / 4w \qquad (1)$$

where $\varepsilon_r$ is the relative dielectric constant of the semiconductor and L is the finger length. The transit time of carriers travelling at the saturation limited velocity $v_s$ is given by

$$t_{tr} = w / v_s. \qquad (2)$$

Setting the RC time constant equal to the transit time yields an optimized device total response of

$$t_{tot} = L[R\varepsilon_0(I + \varepsilon_r)/2v_s]^{1/2} \qquad (3)$$

where R is the load resistance. In the case of a 50 $\Omega$ load, a 40 $\mu$m $\times$ 40 $\mu$m array on GaAs would have 20 pairs of 0.5 $\mu$m wide fingers. The calculated response is less than 10 ps and the required bias is less than 10 V. These dimensions are well within the capabilities of electron beam lithography and metal lift-off techniques. To obtain a 10 ps response, the distributed (i.e., inductive) effects of the array must be accounted for. However, the first order calculations serve to demonstrate the high frequency potential of the interdigitated photoconductor.

Since the transit times of both carriers are similar, gain of the device is ~1. Speed of the device is limited by the slower of the two types of carriers.

Examples
Example 1

A major surface of a Cr-doped GaAs semi-insulating substrate about 400 $\mu$m thick and having a resistivity of $>10^6$ $\Omega$-cm was cleaned following procedures well-known in the art of semiconductor processing. An interdigitated pattern of aluminum was deposited by evaporation on the cleaned surface to a thickness of about 0.4 $\mu$m to form non-blocking contacts with the semiconductor surface. The fingers were 160 $\mu$m long and 200 $\mu$m wide. The device area was thus $3.2 \times 10^{-4}$ cm$^2$. The finger spacing between electrodes was 5 $\mu$m. A microstrip transmission line of·aluminum, 0.4 $\mu$m thick, associated with each electrode was simultaneously deposited. A ground plane of bulk aluminum served as support for the photodetector and was connected to one of the microstrip lines by a brass tab.

To test the response of the device, the other microstrip line was connected to a coaxial cable and sampling oscilloscope via a microstrip line launcher.

The bias voltage applied to the electrodes was 20 V, which corresponded to a field of 40 kV/cm. The device leakage current at that voltage was less than 0.1 $\mu$A.

Incident optical radiation was at 0.83 $\mu$m, provided by a mode-lock GaAs/(Ga,Al)As diode laser. The 10% to 90% rise time was 50 ps and the 90% to 10% fall time was 50 to 150 ps. The full-width half-maximum pulse response was 85 ps.

The analog bandwidth was greater than 4 GHz (limited by frequency response of the laser). From the pulse response, the extrapolated value was calculated to be about 4.4 to 7 GHz. The device sensitivity was about 0.1 mA/mW.

Example 2

A major surface of a Cr-doped GaAs substrate 400 $\mu$m thick and having a resistivity of $>10^6$ $\Omega$-cm was cleaned following procedures well-known in the art of semiconductor processing. An epitaxial layer of unintentionally doped n-type GaAs was deposited on the cleaned surface by conventional liquid phase epitaxy to a thickness of 5 $\mu$m. An interdigitated pattern of aluminum was evaporated on the epitaxial layer to a thickness of 0.2 $\mu$m to form non-blocking contacts with the semiconductor surface. The fingers were 160 $\mu$m long and 200 $\mu$m wide. The device area was thus $3.2 \times 10^{-4}$ cm$^2$. The finger spacing between electrodes was 5 $\mu$m. A microstrip transmission line of aluminum, 0.2 $\mu$m

thick, associated with each electrode was simultaneously deposited. A ground plane of bulk aluminum served as support for the photodetector, and was connected to one of the microstrip lines by a brass tab.

To test the response of the device, the other microstrip line was connected to a coaxial cable and sampling oscilloscope via a microstrip line launcher.

The bias voltage applied to the electrode was 20 V. The device leakage current at that voltage was less than 0.2 μA.

Incident optical radiation was at 0.83 μm, provided by a mode-locked GaAs/(Ga,Al)As diode laser. The 10% to 90% rise time was 50 ps and the 90% to 10% fall time was 50 to 150 ps. The full-width half-maximum pulse response was 85 ps.

## Claims

1. A high speed photoconductive detector responsive to incident optical radiation comprising:
a) a region of semiconductor material capable of withstanding a high enough electric field to permit generation of holes and electrons at their saturation velocity and having a bandgap less than the energy of said optical radiation;
b) a pair of interdigitated metal electrodes formed on said region, said metal electrodes forming non-blocking contacts with said region, with each digit less than about 5 μm apart; and
c) means for connecting each metal electrode to a transmission line.

2. The detector of Claim 1 further comprising means for applying a bias to said metal electrodes.

3. The detector of Claim 2 in which said semiconductor material comprises GaAs and said bias generates a field of about 30 to 100 kV/cm therein.

4. The detector of Claim 1 in which said region comprises at least a portion of a semiconductor substrate.

5. The detector of Claim 4 in which said substrate comprises semi-insulating GaAs or semi-insulating InP.

6. The detector of Claim 1 in which said region comprises at least a portion of an epitaxial layer formed on a semiconductor substrate.

7. The detector of Claim 6 in which said epitaxial layer is at least about 1 μm thick.

8. The detector of Claim 7 in which said epitaxial layer ranges from about 3 to 5 μm in thickness.

9. The detector of Claim 6 in which said epitaxial layer comprises unintentionally doped n-type GaAs and said substrate comprises semi-insulating GaAs.

10. The detector of Claim 6 in which said epitaxial layer comprises unintentionally doped n-type (Ga,In)As and said substrate comprises semi-insulating InP.

11. The detector of Claim 1 in which said connecting means comprises a microstrip transmission line.

12. A process for fabricating at least one high speed photoconductive detector responsive to incident optical radiation comprising:
a) providing at least one region of a semiconductor material capable of withstanding a high enough electric field to permit generation of holes and electrons at their saturation velocity and having a bandgap less than the energy of said optical radiation;
b) forming a pair of interdigitated metal electrodes on said at least one region, said metal electrodes forming non-blocking contacts with said region, with each digit less than about 5 μm apart; and
c) providing means for connecting each metal electrode to a transmission line.

## Patentansprüche

1. Ein hochgeschwindigkeits-fotoelektrischer Detektor, der empfindlich für einfallende optische Strahlung ist, gekennzeichnet durch:
a) eine Region halbleitenden Materials, die einer solchen elektrischen Feldstärke Widerstand leisten kann, die hoch genug ist, um die Erzeugung von Elektron/Lochpaaren bei ihrer Sättigungsgeschwindigkeit zu ermöglichen und einen Bandabstand aufweist, der kleiner ist als die Energie der optischen Strahlung;
b) ein Paar von miteinander verzahnten Metallelektroden, die auf der Region gebildet sind, wobei die Metallelektroden nichtblockierende Kontakte mit der Region bilden und jeder Zahn weniger als etwa 5 μm Abstand hat; und
c) Vorrichtungen zur Verbindung jeder Metallelektrode mit einer Übertragungsleitung.

2. Detektor nach Anspruch 1, weiterhin gekennzeichnet durch Vorrichtungen zum Anlegen einer Vorspannung an die Metallelektroden.

3. Detektor nach Anspruch 2, dadurch gekennzeichnet, daß das halbleitende Material GaAs aufweist und die Vorspannung eine Feldstärke von etwa 30 bis 100 kV/cm erzeugt.

4. Detektor nach Anspruch 1, dadurch gekennzeichnet, daß die Region wenigstens einen Teil eines Halbleitersubstrates aufweist.

5. Detektor nach Anspruch 4, dadurch gekennzeichnet, daß das Substrat halb-isolierendes GaAs oder halb-isolierendes InP aufweist.

6. Detektor nach Anspruch 1, dadurch gekennzeichnet, daß die Region wenigstens einen Teil einer auf dem halbleitenden Substrat gebildeten epitaxialen Schicht aufweist.

7. Detektor nach Anspruch 6, dadurch gekennzeichnet, daß die epitaxiale Schicht wenigstens etwa 1 μm dick ist.

8. Detektor nach Anspruch 7, dadurch gekennzeichnet, daß die epitaxiale Schicht eine Dicke im Bereich von etwa 3 bis 5 μm aufweist.

9. Detektor nach Anspruch 6, dadurch gekennzeichnet, daß die epitaxiale Schicht eine verunreinigungsmäßige Dotierung mit n-Typ GaAs aufweist und das Substrat halb-isolierendes GaAs enthält.

10. Detektor nach Anspruch 6, dadurch gekennzeichnet, daß die epitaxiale Schicht verunreinigungsmäßig mit n-Typ (Ga, In)As dotiert ist und das Substrat halb-isolierendes InP aufweist.

11. Detektor nach Anspruch 1, dadurch gekennzeichnet, daß die verbindenden Vorrichtungen eine Microstrip-Übertragungsleitung aufweisen.

12. Ein Verfahren zur Fertigung wenigstens eines hoch-geschwindigkeits-fotoelektrischen Detektors, der für einfallende optische Strahlung empfindlich ist, gekennzeichnet durch:

a) Erzeugung wenigstens einer Region von halbleitendem Material, das einer solchen elektrischen Feldstärke widerstehen kann, die hoch genug ist, um die Erzeugung von Elektron/Lockpaaren bei ihrer Sättigungsgeschwindigkeit zu ermöglichen und einen Bandabstand aufweist, der geringer ist, als die Energie der optischen Strahlung;

b) Bildung eines Paares ineinander verzahnter Metallelektroden auf wenigstens einer Region, wobei die Metallelektroden nicht-blockierende Kontakte mit der Region bilden, wobei jeder Zahn weniger als etwa 5 µm Abstand aufweist; und

c) Erzeugung von Vorrichtungen zur Verbindung jeder Metallelektrode mit einer Übertragungsleitung.

**Revendications**

1. Détecteur photoconducteur rapide sensible à un rayonnement optique incident comprenant:

a) une région de matériau semiconducteur capable de supporter un champ électrique suffisamment élevé pour permettre la génération de trous et d'électrons à leur vitesse de saturation et présentant une bande interdite inférieure à l'énergie due rayonnement optique;

b) une paire d'électrodes métalliques interdigitées formées sur ladite région, ces électrodes métalliques formant des contacts non bloquants avec ladite région, chaque doigt étant séparé d'un autre de moins d'environ 5 µm; et

c) des moyens pour connecter chaque électrode métallique à une ligne de transmission.

2. Détecteur selon la revendication 1, comprenant en outre des moyens pour appliquer une polarisation aux électrodes métalliques.

3. Détecteur selon la revendication 2, dans lequel le matériau semiconducteur comprend du GaAs et ladite polarisation produit un champ d'environ 30 à 100 kV/cm.

4. Détecteur selon la revendication 1, dans lequel ladite région comprend au moins une partie d'un substrat semiconducteur.

5. Détecteur selon la revendication 4, dans lequel le substrat comprend du GaAs semi-isolant ou de l'InP semi-isolant.

6. Détecteur selon la revendication 1, dans lequel ladite région comprend au moins une partie d'une couche épitaxiale formée sur un substrat semiconducteur.

7. Détecteur selon la revendication 6, dans lequel la couche épitaxiale a une épaisseur d'au moins environ 1 µm.

8. Détecteur selon la revendication 7, dans lequel la couche épitaxiale a une épaisseur située dans une gamme d'environ 3 à 5 µm.

9. Détecteur selon la revendication 6, dans lequel la couche épitaxiale comprend du GaAS de type n dopé non intentionnelement et le substrat comprend du GaAs semi-isolant.

10. Détecteur selon la revendication 6, dans lequel la couche épitaxiale comprend du (Ga, In)As de type n dopé non intentionnellement et le substrat comprend du InP semi-isolant.

11. Détecteur selon la revendication 1, dans lequel lesdits moyens de connexion comprennent une ligne de transmission à microbandes.

12. Procédé de fabrication d'au moins un détecteur photoconducteur rapide sensible à un rayonnement optique incident, comprenant les étapes consistant à:

a) prévoir au moins une région d'un matériau semiconducteur capable de supporter un champ électrique suffisamment élevé pour permettre la génération de trous et d'électrons à leur vitesse de saturation et présentant une bande interdite inférieure à l'énergie du rayonnement optique;

b) former une paire d'électrodes métalliques interdigitées sur au moins une région, lesdits électrodes métalliques formant des contacts non bloquants dans ladite région, chaque doigt étant séparé de moins de 5 µm d'un autre; et

c) prévoir des moyens pour connecter chaque électrode métallique à une ligne de transmission.

Fig. 1.

Fig. 2.